# EUROPEAN PATENT APPLICATION

(11) **EP 1 591 833 A2**
(43) Date of publication of application: **02.11.2005**
(21) Application number: 05009113.1
(22) Date of filing: 26.04.2005
(51) Int. Cl.: G03F 7/20

(54) **Exposure method and apparatus**

(30) Priority: 27.04.2004 JP 2004131021
(71) Applicant: CANON KABUSHIKI KAISHA, Ohta-ku, Tokyo (JP)
(72) Inventor: Tsuji, Toshihiko, Ohta-ku Tokyo (JP)
(74) Representative: TBK-Patent

(57) **Abstract**

An illumination optical system that includes an optical integrator for uniformly illuminating an object, and a light guide part for guiding a light to the optical integrator, wherein said light guide part includes a first mirror that has a first opening part, and a second mirror that has a second opening part, the light reflects from the first mirror through the second opening part, and then, reflects from the second mirror, and passes through the first opening part.

## Description

The present invention relates to an illumination apparatus, an exposure apparatus having the same, and a device fabrication method that exposes an object, such as a single crystal substrate and a glass plate for a liquid crystal display ("LCD"). The present invention is suitable, for example, for an illumination apparatus that generates extreme ultraviolet ("EUV") light and illuminates a target surface.

Along with the recent demands on minute fabrication and economy, the improvement of resolution and throughput, and miniaturization of the exposure apparatus have been increasingly required. In the improvement of resolution, shortening the wavelength of exposure light is general, and recently, a projection exposure apparatus using EUV light with a wavelength of 10 to 15 nm (referred to as an "EUV exposure apparatus" hereinafter) has been proposed. The EUV light is easily absorbed by air and helium etc., a mirror surface is polluted by impurities, and a reflectivity decreases. Therefore, the EUV exposure apparatus stores an optical system, a reticle, and an object in a vacuum chamber, and exposes with the inside maintained to the vacuum or the decompression environment.

An illumination apparatus of the EUV exposure apparatus includes a light source that generates the EUV light as the exposure light, and an illumination optical system that uniformly illuminates the reticle by the EUV light. The light source uses, for example, a laser plasma light source. The laser plasma light source irradiates high-intensity pulse laser light onto a target material, such as an inert gases and liquid drops, in the vacuum chamber, generates the high-temperature plasma, and uses the EUV light emitted from the plasma. The light source that uses the target gases etc. is difficult to maintain to the high vacuum, but it is necessary to maintain since the illumination optical system to the high vacuum. Then, recently, installing a differential pumping part between the light source and the illumination optical system is examined.

On the other hand, the laser plasma light source generates flying particles called debris when the EUV light is generated. The debris causes contamination, damage, lowered reflectance and lowered throughput of an optical element. Therefore, it is necessary to prevent the debris from reaching the illumination optical system. Then, a debris removing member is installed between an emission point of EUV light and the illumination optical system, and it is effective to condense the EUV light that spreads in other directions by the condenser mirror. As a result, the EUV light has an annular shape corresponding to the outline of the debris removing member.

Japanese Patent Applications Publication Nos. 2004-103731, 2004-6716, and 2003-22950 are the prior art.

The illumination optical system includes an optical integrator to uniformly illuminate the reticle and a light guide part that guides approximately parallel light to the optical integrator. The present inventor examined the throughput of the Schwarzschild type light guide part that consists of a convex mirror and a hollow concave mirror to effectively uses the EUV light from the annular outline of the debris removing member. Concretely, the hollow concave mirror is arranged at the reticle side and the convex mirror is arranged at the light source side. The light from the light source is reflected from surroundings of the concave mirror to the convex mirror, and the convex mirror makes the parallel light from the reflected light and supplies it to the optical integrator through an opening in the center part of the concave mirror. The optical system can maintain the proper amount of the EUV light because the optical system receives the proper amount of EUV light of the annular shape and can be converted into the parallel light.

However, the above Schwarzschild type has several faults.

In other words, because a differential pressure of the emission point of the EUV light and the illumination optical system is too large, the differential pressure between them can not be maintained by one differential pumping part, and gas and garbage on the light source part side flow into the illumination optical system side. The present inventor examined installing the differential pumping part (differential pumping room) in multistage. Pressure that is about 10 Pa in the vicinity of the emission point of the EUV light is gradually decompressed to 10⁻¹ Pa and 10⁻² Pa etc., and finally, the differential pressure of 10⁻⁴ Pa that is the vacuum level of the illumination optical system can be secured by installing the differential pumping part in multistage. However, when the differential pumping part in multistage, it is necessary to reduce a convergent angle using the condenser mirror when one differential pumping part is used. When the convergent angle becomes small, it is necessary to make convex mirror of the Schwarzschild type light guide part minute or to separate the light guide part from the condenser point.

If the minute convex mirror is used, the reflected light from the concave mirror condenses on the minute area and heats up the convex mirror, and causes problems such as a heat deformations of the convex mirror etc. Moreover, because the light from the light source is incident on the concave mirror but outside the circumference of the convex mirror, it is difficult to retain the convex mirror without shading the incidence light from the concave mirror. Therefore, a retainer member generates the light amount loss. On the other hand, the exposure apparatus enlarges if the light guide part is separated from the condenser point.

Accordingly, the present invention provides an illumination apparatus, an exposure apparatus having the same, and a device fabrication method that brings miniaturization of apparatus while maintaining a prescribed differential pressure.

An illumination optical system according to one aspect of the present invention includes an optical integrator for uniformly illuminating an object, and a light guide part for guiding a light to the optical integrator, characterized in that the light guide part includes a first mirror that has a first opening part, and a second mirror that has a second opening part, wherein the light reflects from the first mirror through the second opening part, and then, reflects from the second mirror, and passes through the first opening part.

An illumination apparatus according to another aspect of the present invention includes a light source part for generating a light that has an annular shape, and an illumination optical system for illuminating an object with the light from the light source part, characterized in that the optical integrater includes an optical integrator for uniformly illuminating an object, and a light guide part for guiding a light to the optical integrator, wherein said light guide part includes a first mirror that has a first opening part, and a second mirror that has a second opening part, wherein the light reflects from the first mirror through the second opening part, and then, reflects from the second mirror, and passes through the first opening part.

An exposure apparatus according to another aspect of the present invention includes an illumination optical system for illuminating a mask formed with a predetermined pattern as an object to be illuminated, and a projection optical system for projecting the pattern of the mask onto an object to be exposed characterized in that the illumination optical system includes, an optical integrator for uniformly illuminating the object to be illuminated, and a light guide part for guiding a light to the optical integrator, wherein the light guide part includes a first mirror that has a first opening part, and a second mirror that has a second opening part, wherein the light reflects from the first mirror through the second opening part, and then, reflects from the second mirror, and passes through the first opening part.

A device fabrication method according to another aspect of the present invention includes the steps of exposing an object using an exposure apparatus, and developing the object to be exposed, characterized in that the exposure apparatus includes an illumination optical system for illuminating a mask formed with a predetermined pattern as an object to be illuminated, and a projection optical system for projecting the pattern of the mask onto the object to be exposed, wherein the illumination optical system includes an optical integrator for uniformly illuminating the object to be illuminated, and a light guide part for guiding a light to the optical integrator, wherein said light guide part includes a first mirror that has a first opening part, and a second mirror that has a second opening part, wherein the light reflects from the first mirror through the second opening part, and then, reflects from the second mirror, and passes through the first opening part.

Other objects and further features of the present invention will become readily apparent from the following description of the preferred embodiments with reference to the accompanying drawings.
FIG. 1 is schematic structure view of an exposure apparatus of a one embodiment according to the present invention.
FIG. 2 is an enlarged sectional view of a neighborhood of a differential pumping mechanism and a light guide part of the exposure apparatus shown in FIG. 1.
FIG. 3 is an enlarged sectional view of a light guide part that is basic of the light guide part shown in FIG. 2.
FIG. 4 is a schematic perspective view of a reflection type integrator having plural convex and concave cylindrical surfaces.
FIG. 5 is a partially sectional view of the cylindrical surface of the integrator shown in FIG. 4.
FIG. 6 is a view for explaining an angular distribution of the reflected light from the convex cylindrical surface shown in FIG. 4.
FIG. 7 is a view of an arc area that is formed by the reflected light from the cylindrical surface shown in FIG. 5.
FIG. 8 is an enlarged sectional view of from an optical integrator to a slit of the exposure apparatus shown in FIG. 1.
FIG. 9 is a schematic plane view of scan exposure start and end states of the exposure apparatus shown in FIG. 1.
FIG. 10 is an enlarged sectional view of a changeable arc slit and a masking blade of the exposure apparatus shown in FIG. 1.
FIG. 11 is a view of an operation of the masking blade shown in FIG. 10 during scanning exposure.
FIG. 12 is an enlarged sectional view of a masking imaging system of the exposure apparatus shown in FIG. 1.
FIG. 13 is a schematic plane view of a various shape of an aperture stop of the exposure apparatus shown in FIG. 1.
FIG. 14 is a flowchart for explaining a method for fabricating devices.
FIG. 15 is a detailed flowchart for step 4 of wafer process shown in FIG. 14.

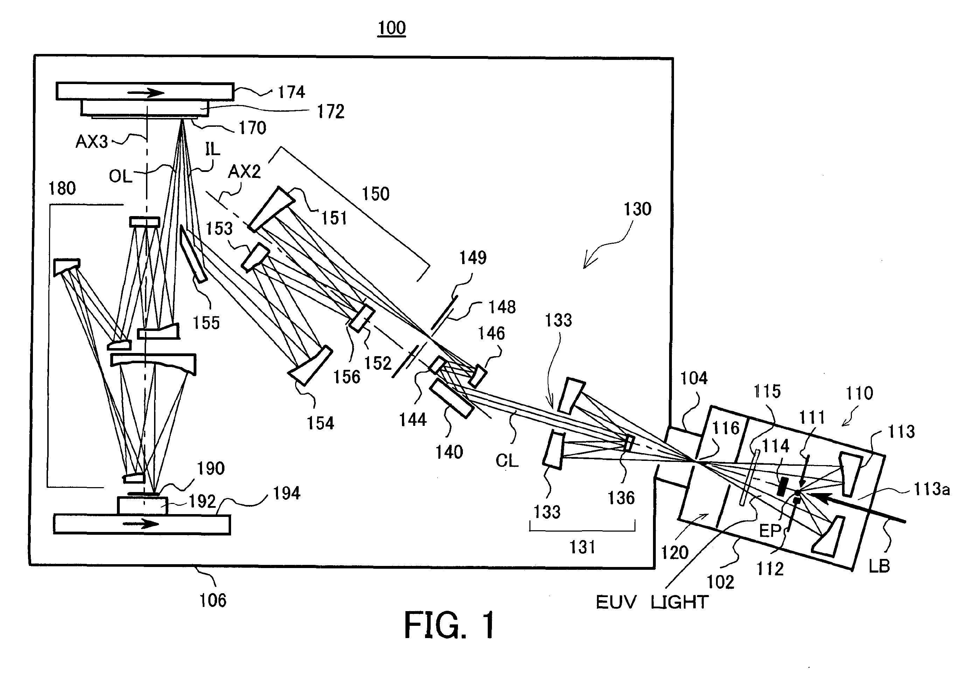

Referring to FIG. 1, a description will be given of an exposure apparatus 100 according to one aspect of the present invention. Here, FIG. 1 is a schematic structure view of the exposure apparatus 100. The exposure apparatus 100 includes, mechanically, a vacuum chamber 102 and 106, and a connector 104 that connects the vacuum chamber 102 to the vacuum chamber 106. Moreover, the exposure apparatus 100 includes a light source part 110, an illumination optical system 130, a mask 170, a projection optical system 180, and a plate 190.

The vacuum chambers 102 and 106, and the connector 104 maintain the components of the exposure apparatus in the vacuum atmosphere for reduced attenuation of the EUV light. The vacuum chamber 102 accommodates the light source part 110. The vacuum chamber 106 accommodates the illumination optical system 140 to the plate 190. If there is a necessity, the vacuum chamber 106 divides the optical system (130 and 180), the mask 170, and the plate 190, and controls these pressures individually. In FIG. 1, an exhaust apparatus connected to each vacuum chamber and an alignment mechanism that precisely matches the position of the mask 170 and the plate 190 are omitted.

The exposure apparatus 100 is an exposure apparatus that uses, as exposure light, EUV light (e.g., with a wavelength of 13.4 nm) to perform a step-and-scan or step-and-repeat exposure that transfers a circuit pattern on the mask 170 onto the plate 190 to be exposed. The exposure apparatus 100 is applicable to a lithography process below submicron or quarter-micron, and a description will be given below of this embodiment using a step-and-scan exposure apparatus (which is also called "a scanner"). The step-and-scan manner, as used herein, is an exposure method that exposes a mask pattern onto a wafer by continuously scanning the wafer relative to the mask, and by moving, after a shot of exposure, the wafer stepwise to the next exposure area to be shot. The step-and-repeat manner is another mode of exposure method that moves a wafer stepwise to an exposure area for the next shot every shot of cell projection onto the wafer.

An illumination apparatus that illuminates the mask 170 with the EUV light includes the light source part 110 and the illumination optical system 130.

The light source part 110 of the instant embodiment uses a laser plasma light source, and includes an excitation laser light source (not shown), an excitation laser part that includes a condenser optical system (not shown), a nozzle 111, a recovery part 112, a condenser mirror 113, a debris removing member 114, a color filter 115, and an aperture 116.

The laser plasma light source that irradiates a high-intensity pulse laser light (excitation laser light) LB from the excitation laser part onto a target material in the vacuum chamber, generates the high-temperature plasma, and uses the EUV light having a wavelength of about 13.4 nm emitted from an emission point EP. The excitation pulse laser LB condenses the emission point EP. The target material uses a material thin coating, inert gases and liquid drops etc., and uses, in the instant embodiment, a liquid drop that consists of Xe. The liquid drop is injected from the nozzle 111, non-used liquid drop is recovered by the recovery part 112, and recycled. The liquid drop is configured to be continuously injected at regular time intervals from the nozzle 111, and passes the emission point EP. When the thus-injected liquid drop is located at the position of the emission point EP, the excitation laser beam LB irradiates liquid drops to generate the high-temperature plasma from the emission point EP, and thermal radiation from this plasma generates the EUV light. The laser beam LB preferably has high repetitive frequency, e.g., usually several kHz, for increased average intensity of the emitted EUV light EL from the plasma.

The kind of the light source part 110 is not limited, and any known techniques can be applied to the light source part 110. While the instant embodiment uses Xe liquid drops as a target, the target may use Xe gas injected into a vacuum, a cluster generated from an adiabatic expansion, solidified Xe gas that has been cooled on the metal surface, and a metal tape, such as Cu. Alternatively, the EUV light source can use an undulator, or a so-called discharge method, such as Z pinch method, a plasma focus, and a capillary discharge.

The condenser mirror 113 condenses EUV light that is radiated approximately isotropically from the plasma emission point EP, and is composed of a spheroid mirror etc. that condenses on the illumination optical system side. Although not described specifically, a reflective surface of each mirror in the optical system forms a reflective multilayer to effectively reflect the EUV light, and the mirror can be made of a material with high thermal conductivity, such as metal, as required. In the instant embodiment, the laser beam LB is irradiated to the target through an opening part 113a installed in the condenser mirror 113, however, it is optional whether to install the opening part 113a in the condenser mirror 113. In this case, for instance, the laser beam LB is downward irradiated from the paper vertical upper side of FIG. 1 to the target.

The debris removing member 114 is a filter that removes debris produced at the same time as the EUV light is generated, and is arranged on the illumination optical system side in view of the mirror with a predetermined size as shown in FIG. 1. As a result, the EUV light becomes annularly shaped. The colour filter 115 removes the light with wavelength other than the EUV light. The aperture 116 is arranged near the condenser point of the condenser mirror 113, and has a pinhole shape.

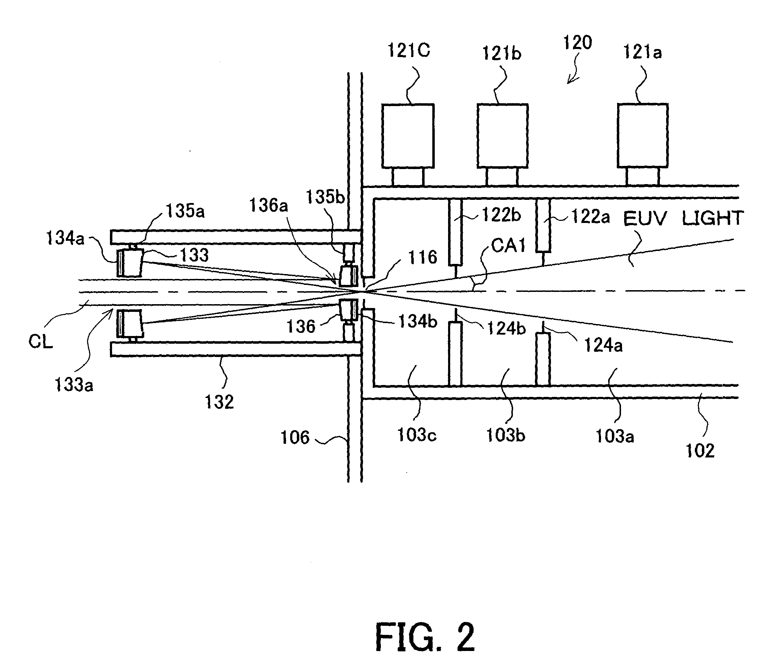

A multistage differential pumping mechanism 120 that is installed in the light source part 110, as shown in FIG. 2, gradually decreases internal pressure from the emission point EP to the vacuum chamber 106. Here, FIG. 2 is a schematic enlarged sectional view of a light guide part 131 and the differential pumping mechanism 120. The connector 104 shown in FIG. 1 is not included in FIG. 2, and the position of the pinhole is also different. However, FIG. 2 shows a structure that is using a differential pumping chamber and the connector in combination. The connector may be arranged on the light source side or the main body side from the pinhole. The differential pumping mechanism 120 includes a vacuum pump 121a, 121b, and 121c, partitions 122a and 122b, and a connecting controller 124a and 124b. The vacuum chamber 102 is divided into an exhaust chamber 103a that includes the emission point EP and a differential pumping chamber 103b and 103c by the partitions 122a and 122b. The vacuum pump 121a to 121c is, in the instant embodiment, a turbo-molecular pump though not specified.

The vacuum pump 121a to 121c exhausts the exhaust chamber 103a, the differential pumping chamber 103b and 103c, respectively. The exhaust chamber 103a has, for instance, the pressure of about 1×10 Pa. The differential pumping chamber 103b has, for instance, the pressure of about 1×10⁻¹ Pa. The differential pumping chamber 103c has, for instance, the pressure of about 1×10⁻² Pa. Thereby, the vacuum level of the exhaust chamber 103a is generally lowered. This is because there are large amounts of the target gas such as Xe, and non-condensed light near the plasma, the differential pumping can not be effectively done even if exhausting with a high performance turbo-molecular pump. Moreover, trying to make a part where Ar or He gas is used and pressure is large, and suppress an influx of the target gas so that the target gas with large absorption of EUV light should not flow in the main body of the exposure apparatus side, and to use a gas curtain to suppress flying particles (debris) from the plasma becomes a possibility to decrease the vacuum level of the exhaust chamber 103a.

On the other hand, the vacuum chamber 106 must be maintained to the very high vacuum level of about 1×10⁻⁴ Pa to prevent pollution of the reflection multilayer surface of the mirror and decrease in reflectivity. At least one or more differential pumping chambers are installed because there is a difference in the vacuum level between the exhaust chamber 103a and the vacuum chamber 106. Both are connected while the vacuum level is gradually decreased. In the instant embodiment, two differential pumping chambers 103b and 103c have been illustratively installed.

The connecting controller 124a and 124b allows light to pass through to adjacent exhaust chambers when the pulse laser light LB is emitted, and shuts off the adjacent exhaust chambers when the pulse laser beam LB is not emitted. The connecting controller 124a and 124b is arranged in a channel part, includes an opening part through which the pulse light passes, and a shield part that shuts off adjacent exhaust chambers, and is composed of a disk or cylinder form rotation body that is rotatable about an axis, and a controller that controls the rotation of the rotation body synchronizing with emission of the pulse light so that the pulse light may pass the aperture part. However, this structure is a mere illustration.

The illumination optical system 130 is an optical system that guides the EUV light and illuminates the mask 170, includes the light guide part 131, an optical integrator 140, an optical unit 144 and 146, slit 148, a masking blade 149, a masking imaging system 150, and an aperture stop 156.

The light guide part 131 guides the approximately parallel EUV light CL to the optical integrator 140, and includes, as shown in FIG. 2, a holding frame 132, a concave mirror 133 that has an opening part 133a, a cooling mechanism 134a and 134b, a retainer mechanism 135a and 135b, and a convex mirror 136 that has an opening part 136a. The holding frame 132 has a cylindrical shape that holds the concave mirror 133 and the convex mirror 136 by the retainer mechanism 135a and 135b, is open without the retainer part, and an internal pressure of the holding frame 132 is the same as an internal pressure of the vacuum chamber 106.

The EUV light that has passed through the aperture 116 is emanated at the same angle as a convergent angle CA1, passes the circular opening part 136a of the convex mirror 136, and is incident on the concave mirror 133. Next, the EUV light that has reflected at the surroundings of the concave mirror 133 is converted into the parallel light CL by reflecting from the convex mirror 136. The parallel light CL passes through the circular opening part 133a at the center of the concave mirror 133, and is incident on the optical integrator 140. Such a structure receives the proper EUV light of annular shape, and can be converted into parallel light CL, therefore, can maintain the light amount of EUV light.

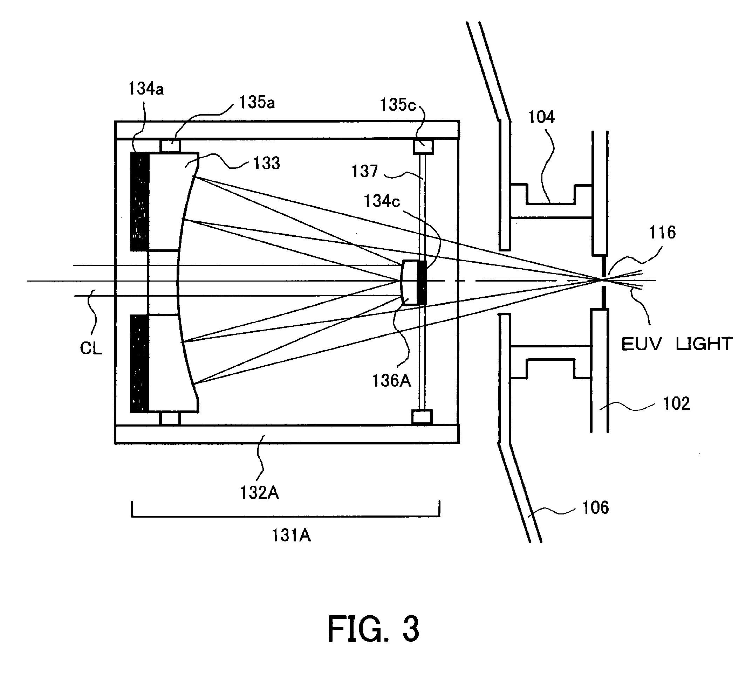

Such a feature is obtained when the convex mirror 136 does not include the opening part 136a and the light guide part 131 as in the Schwarzschild type light guide part 131A shown in FIG. 3. Here, FIG. 3 is a schematic structure view of the Schwarzschild type light guide part 131A that is basic of the light guide part 131 shown in FIG. 2. In the light guide part 131A, the EUV light passes outside the circumference of the convex mirror 136A, and reflects from the concave mirror 133, and then, reflects from the convex mirror 136A, and exits at the optical integrator 140 side as approximately parallel light CL.

The convex mirror 136A is provided and integrated with the cooling mechanism 134c that uses water-cooling on its rear surface, and is cooled from its rear surface when a cooling water circulation system (not shown) circulates water in this cooling mechanism 134c. The convex mirror 136A is held by two or more rods 137. These rods 137 contact the holding frame 132A by a retainer mechanism 135c, similar to the retainer mechanism 135a, and hold and precisely control the concave mirror 136A in the holding frame 132A. The holding structure that utilizes the rods 137 may employ, for example, four rods, arranged orthogonal to each other, and fixes the convex mirror 136A at the cross center. A rotationally symmetrical arrangement of the rods 137 around the center would maintain the excellent illumination since the light distribution maintains the rotational symmetry in the light traveling direction even when the rod 137 partially shields the EUV light. The rod 137 is made of a rigid material, such as metal, and at least two rods are made hollow to allow cooling water to flow. The cooling water circulation system (not shown) allows the cooling water to circulate in the cooling mechanism 134c for the convex mirror 136A.

However, the present inventor discovered that the Schwarzschild type light guide part 131A is difficult to install in the multistage differential pumping mechanism 120. In other words, when the multistage differential pumping mechanism 120 is installed, the interval between the emission point EP and the aperture 116 must be established. If the convergent angle CA1 of the EUV light is constant, an effective diameter of the condenser mirror 113 increases when the above-mentioned interval is established. Because an effective diameter of the condenser mirror 113 increases when the above-mentioned interval is established, if the convergent angle CA1 of the EUV light is constant, it is not possible to manufacture a highly accurate mirror. Therefore, it is necessary to establish the interval for the condenser mirror 113 of the effective diameter provided for beforehand. As a result, the convergent angle CA1 is only decreased compared with the case without the differential pumping. Because the Schwarzschild type light guide part 131A passes the EUV light outside the circumference of the convex mirror 136A, a space where the convex mirror 136A can exist is limited when the convergent angle CA1 is small, and the effective diameter and thickness becomes extremely small.

As a result, an energy density of the EUV light converged to the reflection surface of the convex mirror 136A increases, and the damage to the reflection multilayer film is easily caused by heat destruction and other energy absorption. Therefore, the rod 137 shuts out the large amount of EUV light that is incident to the concave mirror 133. In this case, if the light guide part 131 is separated from the aperture 116, the problem is solved, but the vacuum chamber 106 size is increased.

In the instant embodiment shown in FIG. 2, to solve these problems, the opening part 136a is installed at the center of the concave mirror 136. Because the restriction of the effective diameter of the concave mirror 136 is removed by such structure, the mirror can be made to the desired size. If an incidence area of the reflected light from concave mirror 133 is small, the heat is transmitted to the entire convex mirror 136, and cooling the entire convex mirror 136 can prevent the heat destruction. In the instant embodiment, the convergent angle CA1 is about 10 degree (NA 0.18), a curvature radius of concave mirror 133 is 499.5 mm, a curvature radius of convex mirror 136 is 487.9 mm, the interval between the concave mirror 133 and the convex mirror 136 is 353.9 mm, the distance from the emission point EP to the concave mirror 133 is 428.9 mm, and the diameter of the parallel light CL is 63 mm. The instant embodiment is suitable when NA of the convergent angle CA1 are 0.25 or less, especially 0.2 or less.

The cooling mechanism 134a and 134b are connected to the rear surface of the concave mirror 133 and the convex mirror 136 respectively, and the concave mirror 133 and the convex mirror 136 are water-cooled by which the water circulates in the cooling mechanism 134a and 134b by the cooling water circulating system (not shown). The retainer mechanism 135a and 135b are connected with the side surface of the concave mirror 133 and convex mirror 136 at equal intervals, respectively, and the concave mirror 133 and the convex mirror 136 are installed in the holding frame 132. The retainer mechanism 135a and 135b include a position fine adjustment mechanism, such as a parallel linkage including a piezo-electic element, which precisely controls an orientation of the concave mirror 133 and the convex mirror 136.

The optical integrator 140 forms a plural secondary light source to uniformly illuminate the mask 170 with a predetermined aperture, and includes a plural wave-type cylindrical surface mirror. 144 is a plane mirror, and 146 is a rotation parabolic mirror. 148 is a slit that has an arc opening part, and the width is partially changeable. An arc illuminated area that has a uniform illumination distribution is formed at the opening part of the arc slit 148 by condensing the light that is reflected from each cylindrical surface of the optical integrator 140 and emanates in the arc-shape to the mirror 144 and 146. Therefore, the optical element 140, 144 and 146 form an arc changing optical system.

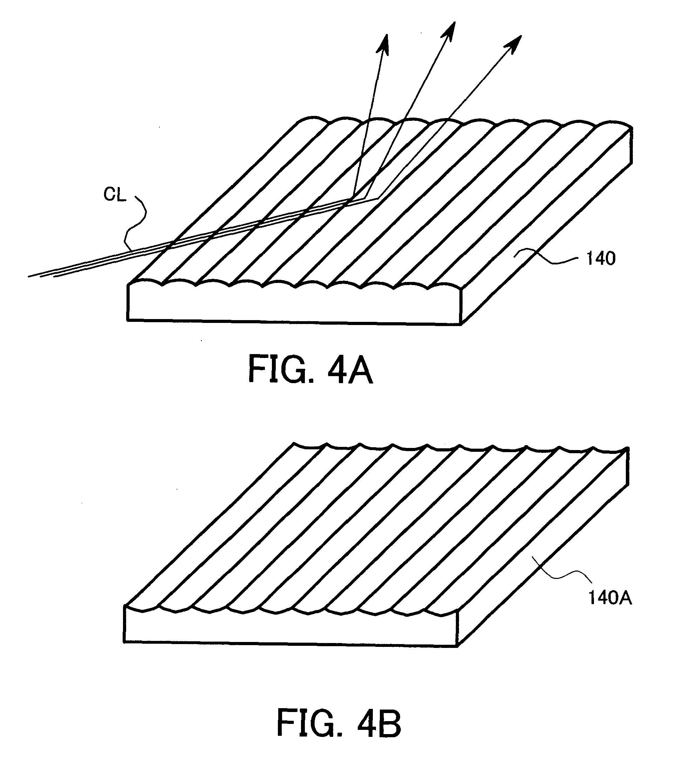

A detailed description will be given of how the optical integrator 140 uniformly illuminates the arc area, with reference to FIGs. 4 to 7. FIG. 4A is a schematic perspective view of the reflection convex cylindrical integrator 140 having plural convex cylindrical surfaces which receives parallel light. The approximately parallel EUV light CL enters in the illustrated direction. FIG. 4B is a typical perspective view of a reflection concave cylindrical integrator having plural concave cylindrical surfaces that exhibit similar effects to FIG. 4A. The optical integrator 140 in FIG. 1 is a reflection convex cylindrical integrator, as shown in FIG. 4A, but it may be a reflection concave cylindrical integrator shown FIG. 4B or a combination thereof.

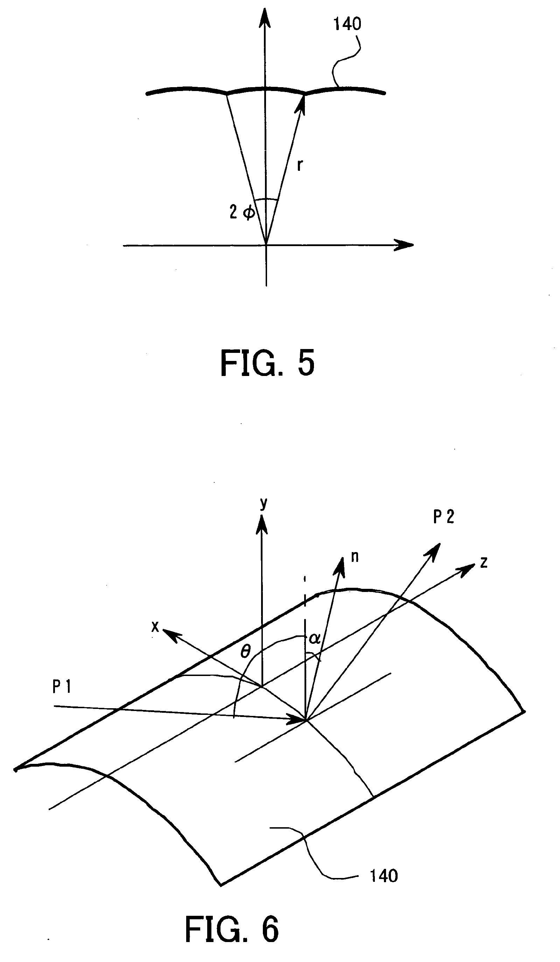

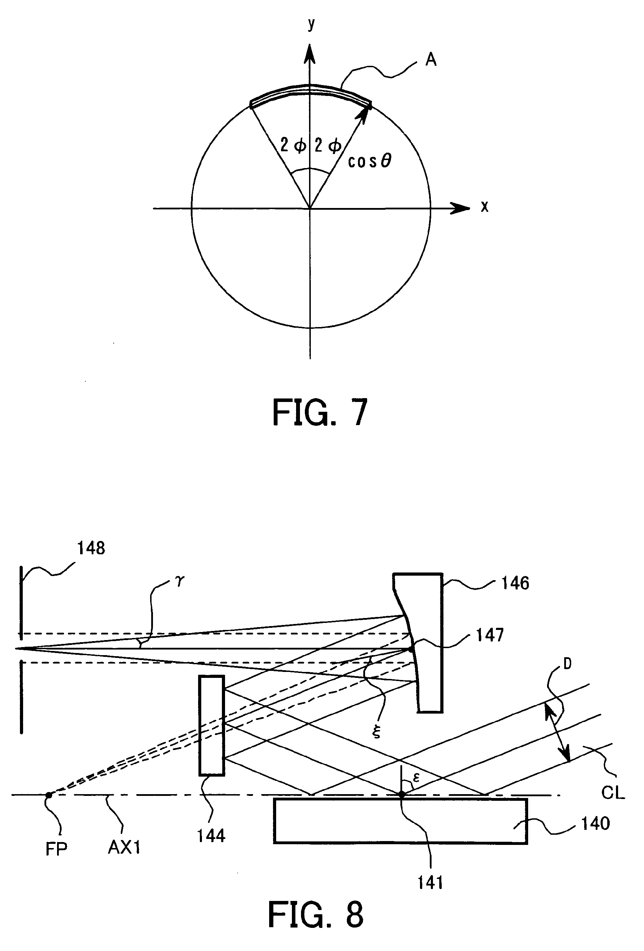

FIG. 5 is a schematic sectional view of the reflection convex cylindrical integrator 140. FIG. 6 is a schematic perspective view for explaining reflection of the EUV light on the cylindrical surface of the reflection convex cylindrical integrator 140. FIG. 7 is an angular distribution diagram of the EUV light reflected from the reflection convex cylindrical integrator 140. As shown in FIG. 4, when approximately parallel EUV light CL is incident upon the optical integrator 140 having plural cylindrical surfaces, the secondary light source is formed near the optical integrator 140 surface and the EUV light radiated from this secondary light source has a cone angular distribution. Then, the arc illumination is available by reflecting the EUV light on the mirror that has a focal point at a position of this secondary light source, and illuminating the reflection mask or a surface conjugate with the reflection mask.

In order to explain operations of the reflection integrator having plural cylindrical surfaces, a description will now be given of a behavior of the reflected light when the parallel light is incident upon one cylindrical mirror with reference to FIG. 6. It is now supposed that parallel light is incident upon one cylindrical surface at an angle θ to a surface perpendicular to the center axis. When a ray vector of the incident parallel light is defined as P1=(0, -cosθ, sinθ), and a normal vector on the cylindrical reflective surface is defined as n=(-sina, cosa, 0), the ray vector of the reflected light becomes P2=(-cosθ x sin2a, cosθ x cos2a, sinθ).

The plotted ray vector of the reflected light in a phase space forms a circle with a radius of cosθ on a xy plane, as shown in FIG. 6. Therefore, the reflected light becomes cone divergent light, and the secondary light source is located on a vertex of this cone surface. When the optical integrator 140 has a concave cylindrical surface, this secondary light source exits as a real image outside the reflective surface, whereas when the optical integrator 140 has a convex cylindrical surface, this secondary light source exits as a virtual image inside the reflective surface. As shown in FIG. 5, when the reflective surface is limited to part of the cylindrical surface and has a center angle of 2F, the ray vector P2 exists as an arc A having a center angle 4F on the xy plane as shown in FIG. 7.

Then, suppose there is a rotational paraboloid mirror having a focal distance f and a focal point at the secondary light source's position formed as a result of parallel light incident upon the above cylindrical mirror, and an illuminated surface located apart from this mirror by the distance f. The secondary light source emits the cone divergent light, which is then reflected on the mirror having the focal distance f and then converted into parallel light. The reflected light is a sheet beam having an arc section with a radius f x cosθ and a center angle of 4F. Therefore, as shown in FIG. 7, only the arc area A is illuminated with a radius of f x cosθ and a center angle of 4F on the illuminated surface.

Referring now to FIG. 8, a description will be given of the optical integrator 140 that arranges a multiplicity of cylindrical surfaces in parallel on a large area, and receives the parallel light CL with a certain beam diameter in a direction shown in FIG. 1. Here, FIG. 8 is a view for explaining an action of the optical system (140 to 148) receiving the parallel light CL.

The rotational paraboloid mirror 146 is a mirror that is centrically symmetrical around an axis AX1, and has a reflective surface that is part of a surface formed by rotating a paraboloid having a focal point FP around the axis AX1. A distance between the focal point FP and the mirror effective part's center point 147 is the focal distance f. A distance between the point 147 and the arc slit 148 is set to be approximately equal to the focal distance A. The rotational paraboloid mirror 146 is arranged so that its rotational axis AX1 is arranged parallel to the reflective surface on or near the reflective surface of the optical integrator 140, and aligned with the cylindrical surfaces.

The plane mirror 144 is located between the effective part's center point 147 and the focal point FP on the rotational paraboloid mirror 146, the point 141 that is symmetrical to the focal point FP with respect to the reflective surface of the mirror 144 can be located approximately at a center position of the reflective surface's effective part on the optical integrator 140. In other words, an optical path length from the position 147 to the position 141 is equal to the focal distance f.

This arrangement provides the position 141 and arc slit 148 with a separation by the focal distance f from the rotational paraboloid mirror 144 or a relationship of the Fourier conversion surface. Therefore, the light CL incident upon the optical integrator 140 is condensed at or near the opening part of the arc slit 148.

The EUV light to rotational paraboloid mirror 146 has a low incident angle ξ of the primary ray between 0 degree and 45 degree, more specifically, 20 degree. Thereby, the defocus amount reduces when light is condensed in the arc slit 148 and condensing efficiency improves near the arc opening part rather than the high incident angle ξ. Thereby, the optical loss due to shielding reduces, and the illumination system's efficiency improves.

Since the light reflected on the mirror that arranges plural cylindrical surfaces in parallel has the same angular distribution as the above, the arc area is illuminated with a radius f x cose near the arc slit 148, where e is a light incident angle to the optical integrator 140. Since the light incident upon one point near the arc slit 148 results from the entire illuminated area that arranges plural cylindrical surfaces in parallel, the angular range γ, *i*.*e*., condensing NA, becomes γ=D/f, where D is a beam diameter of the approximately parallel EUV light CL. In this case, the arc illuminated area maintains uniform light intensity since the multiple cylindrical surfaces on the optical integrator 140 superimpose the light. In other words, this can achieve effective and uniform arc illumination.

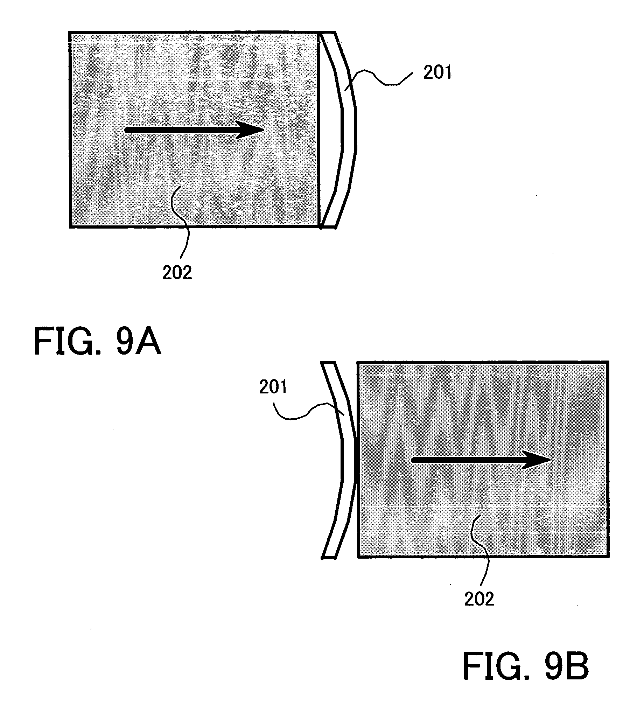

Turning back to FIG. 1, the masking blade 149 restricts the illumination light to the desired exposure area. FIGs. 9A and 9B is a schematic plane view of scan exposure start and end states on the plate 190 surface, respectively. As illustrated, 201 denotes an arc illuminated area on the plate 190 surface. 202 denotes an exposure area as an object to be exposed. The exposure area 202 moves from left to right on the paper when the plate stage is driven. The arc illuminated area 201 is configured to relatively scan the exposure area 202. The masking blade 149 works so that the arc illuminated area 201 is prevented from illuminating part except for the exposure area 202 at the exposure start and exposure end. The scanning direction is acceptable also in the opposite direction.

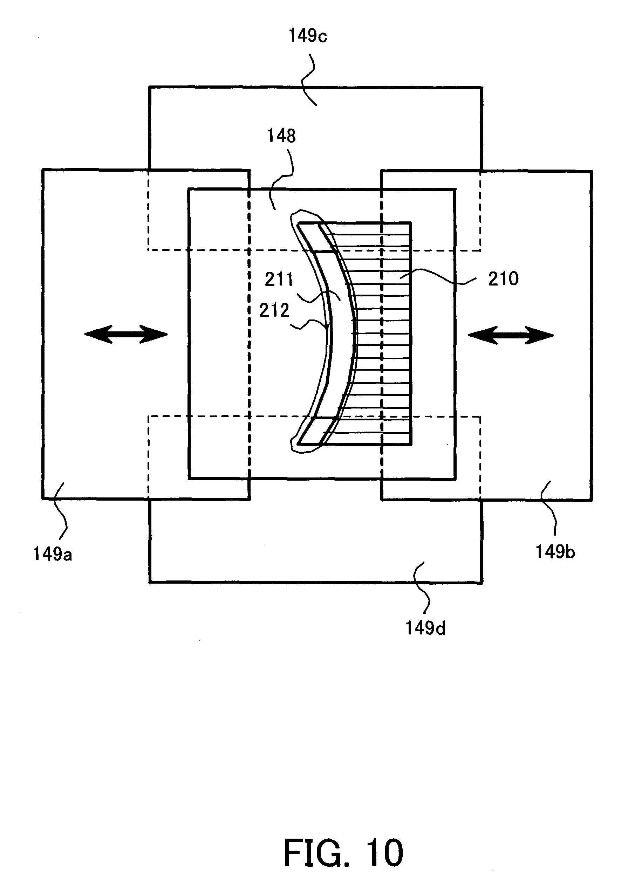

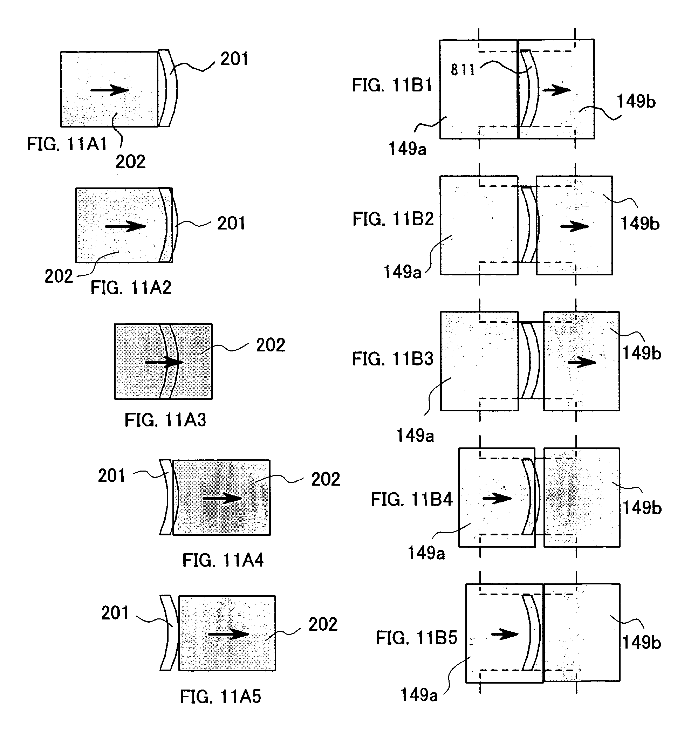

Referring to FIGs. 10 and 11, a detailed description will be given of a method of correcting an uneven exposure with the arc slit 148 in the scan exposure. Here, FIG. 10 is a schematic view of a relationship between the arc slit 148 and the masking blade 149. As illustrated, 210 denotes a multiple movable edges for partially changing a slit width 211 in the arc slit 148. 211 denotes a slit opening part for forming the arc illuminated area. 212 denotes an arc illuminated area formed by the optical integrator 140 and mirror system 144 and 146, and this illuminated area defines light that passes through the slit opening part 211.

The uneven exposure occurs if there is uneven light intensity in the arc slit when the scan exposure transfers a reduced size of the circuit pattern in the mask 170 onto the plate 190. One solution for this problem uses a drive system (not shown) to move the movable edges 210 to narrow only the slit width that provides relatively strong light intensity in the arc slit, and to reduce the light amount for the scan exposure by a desired amount. As a result, exposure with uniform intensity is available on the entire exposed surface as a result.

The masking blade 149 includes four light-shielding plates 149a to 149d, the upper and lower light-shielding plates 149c and 149d shield light at both ends of the arc illuminated area 212 in the arc slit opening part 211, and define a longitudinal width (or a scan width) of the exposure area 202 shown in FIG. 9A. The light-shielding plates 149a and 149b define a lateral width (or a scan length) in the exposure area 202 by moving in a lateral direction and opening and closing an aperture from the exposure start to the exposure end for one shot in the scan exposure.

In FIG. 11, (a1) to (a5) time-sequentially represent scan exposure from a start to an end, while (b1) to (b5) show actions of light-shielding plates 149a and 149b in the masking blade 149 at states (a1) to (a5).

The exposure is about to start at the state (a1), and the light-shielding plate 149b starts to move to the right at the state (b1) to open the aperture. The arc illuminated area 201 is light-shielded in this state, and not actually illuminated although illustrated. When the scan exposure starts as shown in (a2), the light-shielding plate 149b moves as shown in the state (b2) so as to light-shield a projection the arc illuminated area 201 from the exposure area 202. As shown in state (a3), the arc illuminated area 201 moves within the exposure area 202 for scan exposure, the light-shielding plate 149b moves to the right as shown in (b3) to completely open the slit opening part 211. When the scan exposure nearly ends as shown in (a4), the light-shielding plate 149a, in turn, moves to the right so as to light-shield a projection of the arc illuminated area 201 from the exposure area 202. When the scan exposure ends as shown in (a5), the light-shielding plate 149a moves and completely shields the slit opening part 211. The above series of actions provides the scan exposure for a desired exposed area.

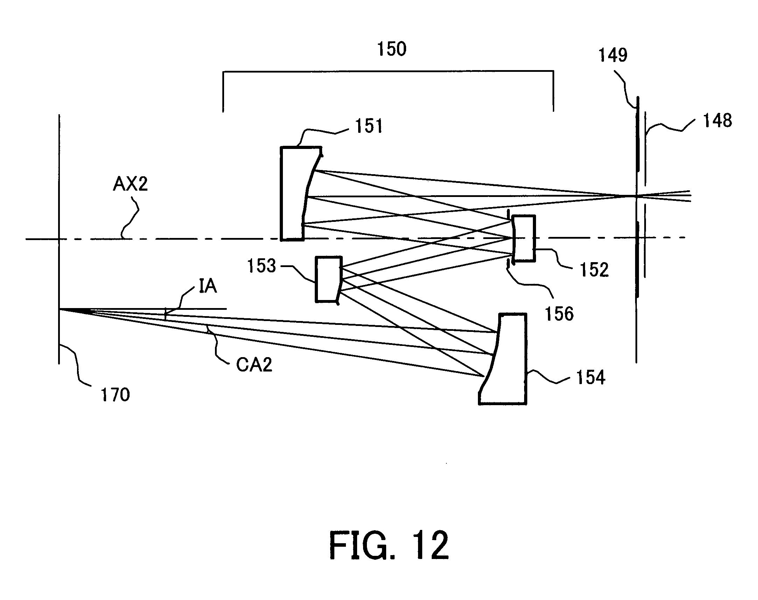

The masking imaging system 150 is, as shown in FIGs 1 and 12, an imaging optical system that uses the masking blade 149 as an object surface, and the mask 170 as an image surface, and includes curved mirrors 151 to 154 that has the reflective multilayer. The masking imaging system 150 serves to image and form an arc illuminated area onto the mask 170 suitable for the projection optical system 180 by applying a desired magnification to the object-side arc area that arranges the axis AX2 approximately at a center. The imaging surface properly corrects defocus at the image side, and the spot diameter on the image surface is designed to be 5 mm or smaller, preferably 1 mm or smaller. The curved mirrors 151 to 154 are concave or convex spherical or aspheric mirrors that use the center axis AX2 for rotational symmetry, and are concave, concave, convex and concave, respectively, in the instant embodiment.

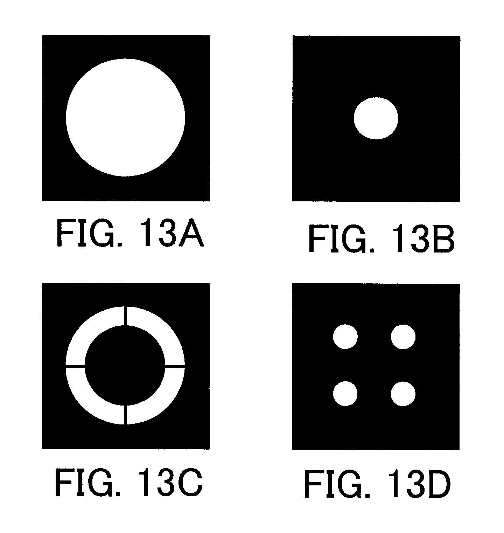

The pupil surface in the masking imaging system 150 is located on or near the reflective surface of the mirror 152, at which the aperture stop 156 is located. The aperture stop 156 changes its opening pattern shown in FIG. 13 to change a convergent angle CA2 (or a so-called coherence factor s) of the illumination light at the mask 170 side, or provides modified illumination. Here, FIG. 13A is a plane view of the aperture stop 156 to form the circular illumination mode, where black part is light-shielding part, and white part is light-transmitting part. Similarly, FIG. 13B is a plane view of the aperture stop 156 that the coherence factor s is smaller than the circular illumination mode shown in FIG. 13A. FIG. 13C is a plane view of the aperture stop 156 that forms the annular illumination mode. FIG. 13D is a plane view of the aperture stop 156 that forms the quadrupole illumination mode. It is possible to switch a desired opening shape by preparing several opening patterns, for example, on a turret, and by rotating this turret using an aperture stop drive system (not shown). Instead of using the turret, other mechanical methods may be used, such as switching of plural aperture stops that are linearly arranged or use of an iris stop.

The masking imaging system 150 further includes a plane mirror 155 that reflects the image-side light IL for entry into the reflection mask 170 at a predetermined angle. An orientation of an arc illuminated area formed by the light IL is reversed and the arc's center accords with an intersection between the center axis AX3 of the projection optical system 180 and reflection mask. The incident angle IA shown in FIG. 12 enables the principal ray of the light IL to accord with the principal ray of the object-side light OL of the projection optical system 180 with respect to a reflective surface on the mask 170.

As a result, the masking blade 149 partially restricts the arc illuminated area formed near the opening in the arc slit 148, and the masking imaging system 150 enlarges or reduces the arc illuminated area at a desired magnification. As a consequence, the mask 170 is illuminated with an arc shape by introducing the arc illuminated area at a desired incident angle into the mask 170. The center of curvature of the illuminated area accords with the optical axis AX3 of the projection optical system 180.

The mask 170 is a reflection type mask, and has a circuit pattern (or image) to be transferred. The pattern is formed by a non-reflected part made of an EUV absorber on a multilayer mirror. The mask 170 is installed in a mask stage 174 through a mask chuck 172, and is driven in the arrow direction by the mask stage 174. The diffracted light emitted from the mask 170 is projected onto the plate 190 after reflected by the projection optical system 180. The mask 170 and the plate 190 are arranged optically conjugate with each other. Since the exposure apparatus 100 of this embodiment is a scanner, the mask 170 and plate 190 are scanned to transfer a reduced size of a pattern of the mask 170 onto the plate 190. The mask 170 is, in the instant embodiment, the reflection type mask, and can apply the reflection type mask or a transmittance type mask.

The projection optical system 180 is comprised of plural (typically four to six) multilayer mirrors, and configured to project a reduced size of pattern on the mask 170 onto the plate 190 surface. The projection optical system 180 forms an image-side telecentric system, and provides an object-side (or the reflection mask side) with a non-telecentric structure so as to avoid physical interference with the illumination light incident upon the reflection type mask 170. The instant embodiment inclines the image-side principal ray, for example, by about 6 degrees relative to the normal direction of the mask 170. The projection optical system 180 is provided with excellent imaging performance in an off-axis, thin arc area.

The plate 190, such as a wafer and a LCD, is an exemplary object to be exposed. Photoresist is applied to the plate 190. A plate stage 194 supports the plate 190 through a plate chuck 192. The plate stage 194 may use any structure known in the art, thus, a detailed description of its structure and operation is omitted. The plate stage 194 may use, for example, a linear motor to move the plate 190 in the XY directions. The mask 170 and plate 190 are, for example, scanned synchronously, and the positions of the plate stage 194 and the mask stage 174 are monitored, for example, by a laser interferometer and the like, so that both are driven at a constant speed ratio.

In exposure, the EUV light irradiated from the plasma emission point EP is condensed by the condenser mirror 113, and taken out as a EUV beam. The filter 114 removes debris that emanate from the plasma and its vicinity, and the filter 115 removes an unnecessary wavelength component for the EUV exposure. Then, the light is condensed in the pinhole aperture 116.

The EUV light that has passed through the aperture 116 passes through the circular opening part 136a of the convex mirror 136, and is incident on the concave mirror 133. The EUV light that has reflected by the concave mirror 133 is converted into the parallel light CL by reflecting from the convex mirror 136. The parallel light CL passes through the circular opening part 133a that is arranged at the center of the concave mirror 133, and is incident to the optical integrator 140. Such a structure receives the EUV light of annular shape without the excess and deficiency, and can be converted into the parallel light CL, therefore, has the feature that the light amount of EUV light can be maintained. Moreover, there is not the light amount loss because it does not use the rod 137 shown in FIG. 3. Because it is possible to cool by maintaining the size of the convex mirror 136 even if the convergent angle CA1 shown in FIG. 2 becomes small by the multistage differential pumping mechanism 120, thermal deformation by the EUV light etc. can be prevented. In addition, because the size of the convex mirror 136 can be maintained, manufacturing and maintenance are also easy.

The EUV light that passes through the optical integrator 140 uniformly arc-illuminates the mask 170 by the other optical elements 144 to 155. The EUV light that reflects the mask pattern is imaged onto the plate 190 by the projection optical system 180.

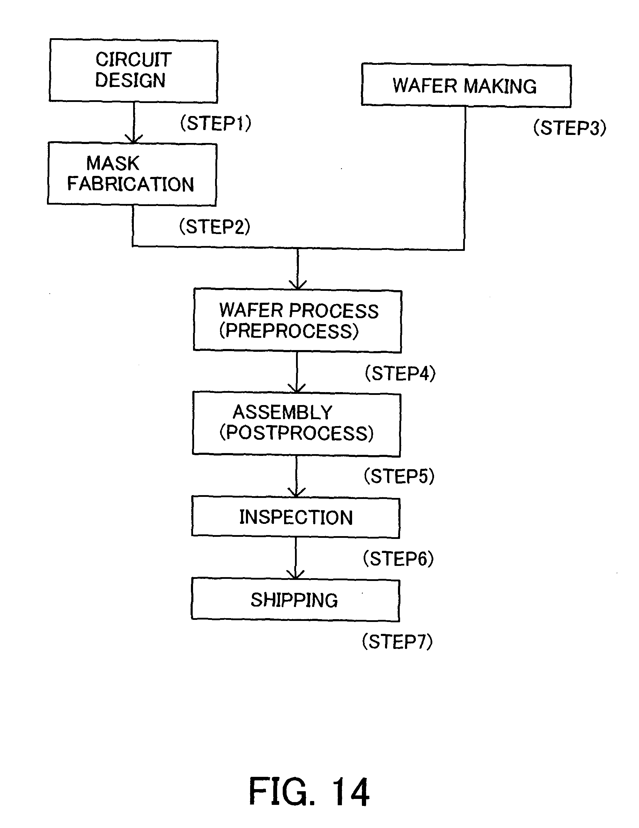

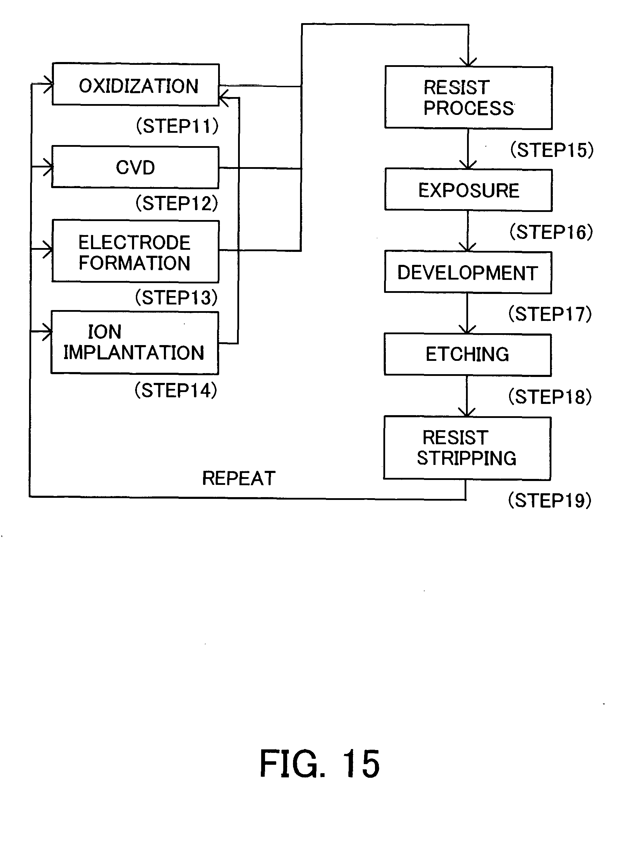

Referring now to FIGs. 14 and 15, a description will be given of an embodiment of a device fabrication method using the above exposure apparatus 100. FIG. 14 is a flowchart for explaining a fabrication of devices (i.e., semiconductor chips such as IC and LSI, LCDs, CCDs, etc.). A description will now be given of a fabrication of a semiconductor chip as an example. Step 1 (circuit design) designs a semiconductor device circuit. Step 2 (mask fabrication) forms a mask having a designed circuit pattern. Step 3 (wafer preparation) manufactures a wafer using materials such as silicon. Step 4 (wafer process), which is referred to as a pretreatment, forms actual circuitry on the wafer through photolithography using the mask and wafer. Step 5 (assembly), which is also referred to as a posttreatment, forms into a semiconductor chip the wafer formed in Step 4 and includes an assembly step (*e*.*g*., dicing, bonding), a packaging step (chip sealing), and the like. Step 6 (inspection) performs various tests for the semiconductor device made in Step 5, such as a validity test and a durability test. Through these steps, a semiconductor device is finished and shipped (Step 7).

FIG. 15 is a detailed flowchart of the wafer process in Step 4 in FIG. 14. Step 11 (oxidation) oxidizes the wafer's surface. Step 12 (CVD) forms an insulating film on the wafer's surface. Step 13 (electrode formation) forms electrodes on the wafer by vapor disposition and the like. Step 14 (ion implantation) implants ion into the wafer. Step 15 (resist process) applies a photosensitive material onto the wafer. Step 16 (exposure) uses the exposure apparatus 100 to expose a circuit pattern on the mask onto the wafer. Step 17 (development) develops the exposed wafer. Step 18 (etching) etches parts other than a developed resist image. Step 19 (resist stripping) removes disused resist after etching. These steps are repeated, and multilayer circuit patterns are formed on the wafer. The fabrication method of the instant embodiment manufactures high-quality devices. In this manner, the device fabricating method that uses the exposure apparatus 100 and the device as a final product constitute one aspect according to the present invention.

Further, the present invention is not limited to these preferred embodiments, but various modifications and variations may be made without departing from the spirit and scope of the present invention. For example, the light guide part 131 of the instant embodiment can be used for non-EUV ultraviolet rays with a wavelength of 200 nm or less such as ArF excimer laser and F₂ excimer laser, as well as to an exposure apparatus that does or does not scan and expose large image planes. The light that is incident to the optical integrator 140 from the light guide part 131 is, in the instant embodiment, approximately parallel light, but the present invention is not limited to this.

An illumination optical system that includes an optical integrator for uniformly illuminating an object, and a light guide part for guiding a light to the optical integrator, wherein said light guide part includes a first mirror that has a first opening part, and a second mirror that has a second opening part, the light reflects from the first mirror through the second opening part, and then, reflects from the second mirror, and passes through the first opening part.

## Claims

1. An illumination optical system includes:
an optical integrator for uniformly illuminating an object; and
a light guide part for guiding a light to the optical integrator,
**characterized in that** the light guide part includes a first mirror that has a first opening part, and a second mirror that has a second opening part,
wherein the light reflects from the first mirror through the second opening part, and then, reflects from the second mirror, and passes through the first opening part.

2. An illumination optical system according to claim 1, **characterized in that** the first mirror is a concave mirror, and the second mirror is a convex mirror.

3. An illumination optical system according to claim 1, **characterized in that** the light guide part guides an approximately parallel light to the optical integrator.

4. An illumination optical system according to claim 1, **characterized in that** the second opening part is arranged at a center part of the second mirror.

5. An illumination optical system according to claim 1 **characterized in that** the light that is incident to the light guide part has a numerical aperture of 0.25 or less.

6. An illumination optical system according to claim 1, **characterized in that** the light that is incident to the light guide part has a numerical aperture of 0.2 or less.

7. An illumination optical system according to claim 1, **characterized in that** the light has a wavelength of 20 nm or less.

8. An illumination apparatus includes:
a light source part for generating a light that has an annular shape; and
an illumination optical system for illuminating an object with the light from the light source part,
**characterized in that** the optical integrator includes:
an optical integrator for uniformly illuminating an object; and
a light guide part for guiding a light to the optical integrator,
wherein the light guide part includes a first mirror that has a first opening part, and a second mirror that has a second opening part,
wherein the light reflects from the first mirror through the second opening part, and then, reflects from the second mirror, and passes through the first opening part.

9. An illumination apparatus according to claim 8, further comprising a multistage differential pumping that is arranged between the light source part and the light guide part, and decompresses gradually to reduce a pressure.

10. An exposure apparatus includes:
an illumination optical system for illuminating a mask formed with a predetermined pattern as an object to be illuminated; and
a projection optical system for projecting the pattern of the mask onto an object to be exposed,
**characterized in that** the illumination optical system includes:
an optical integrator for uniformly illuminating the object to be illuminated; and
a light guide part for guiding a light to the optical integrator,
wherein the light guide part includes a first mirror that has a first opening part, and a second mirror that has a second opening part,
wherein the light reflects from the first mirror through the second opening part, and then, reflects from the second mirror, and passes through the first opening part.

11. A device fabrication method includes the steps of:
exposing an object to be exposed using an exposure apparatus; and
developing the object to be exposed,
**characterized in that** the exposure apparatus includes:
an illumination optical system for illuminating a mask formed with a predetermined pattern as an object to be illuminated; and
a projection optical system for projecting the pattern of the mask onto the object to be exposed,
wherein the illumination optical system includes:
an optical integrator for uniformly illuminating the object to be illuminated; and
a light guide part for guiding a light to the optical integrator,
wherein the light guide part includes a first mirror that has a first opening part, and a second mirror that has a second opening part,
wherein the light reflects from the first mirror through the second opening part, and then, reflects from the second mirror, and passes through the first opening part.
